(19) Europäisches Patentamt
European Patent Office
Office européen des brevets

(11) **EP 4 741 785 A1**

(12) # EUROPEAN PATENT APPLICATION

(43) Date of publication:
**13.05.2026 Bulletin 2026/20**

(21) Application number: **25159730.8**

(22) Date of filing: **24.02.2025**

(51) International Patent Classification (IPC):
**G01K 7/21** (2006.01)     **G01K 7/25** (2006.01)
**G01K 15/00** (2006.01)

(52) Cooperative Patent Classification (CPC):
**G01K 15/005; G01K 7/21; G01K 7/25;** Y02E 60/10

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.11.2024 CN 202411607158**

(71) Applicant: **ZHEJIANG JINKO ENERGY STORAGE CO., LTD.**
**Huangwan Town**
**Haining City, Jiaxing, Zhejiang (CN)**

(72) Inventors:
• **XIAO, Qi**
  **Haining City**
  **Jiaxing, Zhejiang (CN)**
• **TAN, Yaoshen**
  **Haining City**
  **Jiaxing, Zhejiang (CN)**
• **ZHANG, Luhua**
  **Haining City**
  **Jiaxing, Zhejiang (CN)**

(74) Representative: **Algemeen Octrooi- en Merkenbureau B.V.**
**P.O. Box 645**
**5600 AP Eindhoven (NL)**

(54) ## TEMPERATURE SAMPLING CIRCUIT AND TEMPERATURE DETECTION METHOD

(57)     The present disclosure provides a temperature sampling circuit and a temperature detection method used in a power conversion system. The temperature sampling circuit includes: a thermistor; an adjustable reference resistance module connected to the thermistor, the adjustable reference resistance module has multiple stages of different reference resistance values, and the reference resistance values of different stages corresponding to different preset sampling voltage ranges; a sampling circuit connected to the thermistor to obtain a sampling voltage value; a control circuit connected to the sampling circuit output terminal to receive the sampling voltage value and further connected to the adjustable reference resistance module. The control circuit is configured to determine a resistance value of the thermistor when the sampling voltage value meets the preset sampling voltage range of the reference resistance value of the current stage. The control circuit is further configured to switch to another stage with a different reference resistance value of when the sampling voltage value does not meet the preset sampling voltage range of the reference resistance value of the current stage, so that the newly obtained sampling voltage value meets the preset sampling voltage range of the reference resistance value of the new stage, thereby improving the temperature sampling accuracy within the full temperature range.

FIG. 3

EP 4 741 785 A1

**Description**

**TECHNICAL FIELD**

The present disclosure relates to the field of energy storage, and in particular to a temperature sampling circuit and a temperature detection method.

**BACKGROUND**

The power conversion system (PCS) generates a large amount of heat during operation, and temperature detection is required to ensure its safety. The temperature detection can help monitor the health status of the equipment, and detect potential faults in time to prevent damage caused by overheating. Currently, in the temperature detection methods for the PCS, thermistors is usually used to measure temperature, and the ambient temperature is obtained from a lookup table based on the resistance value of the thermistor.

The resistance value of the thermistor is generally measured using a resistive voltage divider, but the temperature detection accuracy still needs to be improved.

**SUMMARY**

In view of this, a temperature sampling circuit and a temperature detection method are proposed to improve accuracy of temperature detection results as compared to the related art.

In a first aspect, embodiments of the present disclosure provide a temperature sampling circuit, applied in a power conversion system. The temperature sampling circuit includes: a thermistor having a first terminal and a second terminal, the first terminal is configured to be connected to a power supply voltage, and the second terminal is configured to be grounded; an adjustable reference resistance module connected to at least one of the first terminal and the second terminal, the adjustable reference resistance module has a plurality of stages of different reference resistance values, and the reference resistance values of different stages correspond to different preset sampling voltage ranges; a sampling circuit having a sampling terminal and a sampling circuit output terminal, the sampling terminal is connected to at least one of the first terminal and the second terminal to obtain a sampling voltage value; a control circuit having a control circuit input terminal and a control circuit output terminal, the control circuit input terminal is connected to the sampling circuit output terminal to receive the sampling voltage value, and the control circuit output terminal is connected to the adjustable reference resistance module. The control circuit is configured to determine a resistance value of the thermistor based on the sampling voltage value in response to the sampling voltage value falling with a preset sampling voltage range corresponding to a reference resistance value of the current stage. The control circuit is further configured to switch to another stage with a different reference resistance value in response to the sampling voltage value not falling within a preset sampling voltage range corresponding to a reference resistance value of the current stage, so that a newly obtained sampling voltage value falling within a preset sampling voltage range corresponding to the reference resistance value of the stage after switching.

In one or more embodiments, the adjustable reference resistance module includes a stage controller and a plurality of reference resistors with different resistance values. The stage controller is connected to at least one of the first terminal and the second terminal. The stage controller is further connected to the control circuit output terminal, and the control circuit output terminal is configured to send a control signal to the stage controller to control one of the plurality of reference resistors with a corresponding resistance value to be connected in series with the thermistor.

In one or more embodiments, the sampling circuit includes an analog-to-digital converter (ADC) module. The ADC module has an ADC module input terminal and an ADC module output terminal. The sampling terminal is the ADC module input terminal, and the sampling circuit output terminal is the ADC module output terminal.

In one or more embodiments, the temperature sampling circuit includes one adjustable reference resistance module. When the adjustable reference resistance module is connected to the first terminal, the sampling terminal is connected to the first terminal; or when the adjustable reference resistance module is connected to the second terminal, the sampling terminal is connected to the second terminal.

In one or more embodiments, the temperature sampling circuit includes two adjustable reference resistance modules. One of the two adjustable reference resistance modules is connected to the first terminal, and the other is connected to the second terminal. The sampling terminal is connected to at least one of the first terminal and the second terminal.

In one or more embodiments, the adjustable reference resistance module includes a first adjustable reference resistance module and a second adjustable reference resistance module. One of the first adjustable reference resistance module and the second adjustable reference resistance module is connected to the first terminal, and the other is connected to the second terminal. The first adjustable reference resistance module and the second adjustable reference resistance module are respectively connected to the control circuit output terminal, so that the control circuit output terminal can respectively send control signals to the first adjustable reference resistance module and the second adjustable reference resistance module. The first adjustable reference resistance module includes N first reference sub-resistors with different resistance values, where N≥2 and N is an integer. The second adjustable reference resistance module includes M second reference sub-resistors with different resistance values, where M≥2 and M is an integer.

In a second aspect, embodiments of the present disclosure provide a temperature detection method, applied in temperature detection of a PCS by a temperature sampling circuit. The temperature sampling circuit includes a thermistor, an adjustable reference resistance module, a sampling circuit, and a control circuit. The adjustable reference resistance module has a plurality of stages of different reference resistance values, and the reference resistance values of different stages correspond to different preset sampling voltage ranges. The temperature detection method includes: selecting a stage with a reference resistance value; obtaining, by the sampling circuit, a sampling voltage value at a sampling point under the current stage; transmitting the sampling voltage value to the control circuit; determining, by the control circuit, the sampling voltage value: when the sampling voltage value falls within a preset sampling voltage range corresponding to the reference resistance value of the current stage, determining a resistance value of the thermistor based on the sampling voltage value, and obtaining a current ambient temperature value based on the resistance value of the thermistor, or when the sampling voltage value does not fall within the preset sampling voltage range corresponding to the reference resistance value of the current stage, switching to another stage with a different reference resistance value, obtaining a new sampling voltage value at the sampling point under the switched stage, and continue determining the new sampling voltage value.

In one or more embodiments, the switching to another stage with a different reference resistance value includes: when the sampling voltage value exceeds an upper limit of the preset sampling voltage range corresponding to the reference resistance value of the current stage, switching to a stage with a greater reference resistance value; or when the sampling voltage value is below a lower limit of the preset sampling voltage range corresponding to the reference resistance value of the current stage, switching to a stage with a smaller reference resistance value.

In one or more embodiments, the determining a resistance value of the thermistor and obtaining a current ambient temperature value includes: calculating, by the control circuit, the resistance value of the thermistor based on the sampling voltage value; and retrieving, by the control circuit, a resistance-temperature comparison table of the thermistor, and obtaining the current ambient temperature value by looking up the table based on the resistance value of the thermistor.

In one or more embodiments, prior to selecting a stage with a reference resistance value, the temperature detection method further includes: determining the number of stages and reference resistance values of all stages of the adjustable reference resistor module based on a range of an ambient temperature to be measured; establishing resistance-temperature comparison tables of the thermistor corresponding to different stages based on temperature characteristics of the thermistor; and selecting a sampling point and setting preset sampling voltage ranges corresponding to reference resistance values of all stages based on actual circuit parameters of the sampling point.

In the temperature sampling circuit according to the embodiments of the present disclosure, the dynamic adjustment of the reference resistance value in the temperature sampling circuit can be achieved by setting an adjustable reference resistance module having multiple reference resistance values of different stages and using the control circuit to achieve the stage adjustment of the adjustable reference resistance module. This enables dynamic adjustment of the reference resistance value in the temperature sampling circuit according to the resistance-value range of the thermistor, so that there is always a suitable reference resistance value for the thermistor at different ambient temperatures. That is, the temperature sampling circuit according to embodiments of the present disclosure can achieve precise matching between the reference resistance value and the thermistor within the full temperature range, reducing the influence of errors in the reference power supply, reference resistance value, and the thermistor itself on the sampling accuracy, thereby improving the sampling accuracy within the full temperature range and ensuring the accuracy of the finally obtained ambient temperature result. Moreover, the temperature sampling circuit according to the embodiments of the present disclosure does not require the use of an additional high-precision reference source or precision resistor, thereby effectively controlling the hardware cost of the temperature sampling circuit.

It should be understood that the above general description and the following detailed description are only exemplary and do not limit the present disclosure.

## BRIEF DESCRIPTION OF DRAWINGS

To more clearly illustrate the technical solutions of embodiments of the present disclosure, the drawings used in the embodiments will be briefly introduced. It is appreciated that, the drawings described below are only some embodiments of the present disclosure. For those of ordinary skill in the art, without creative efforts, other drawings can also be obtained based on these drawings.

FIG. 1 is a circuit structure diagram of a temperature sampling circuit in the related art.

FIG. 2 is a resistance-temperature comparison table corresponding to a negative temperature coefficient (NTC) in FIG. 1.

FIG. 3 is a circuit structure diagram of a temperature sampling circuit according to one or more embodiments of the present disclosure.

FIG. 4 is a circuit structure diagram of a temperature sampling circuit according to one or more embodiments of the present disclosure.

FIG. 5 is a circuit structure diagram of a temperature sampling circuit according to one or more embodiments of the present disclosure.

FIG. 6 is a flowchart of a temperature detection method according to one or more embodiments of the present disclosure.

Reference signs: 10-NTC; 20-First reference resistor; 30-Second reference resistor; 40-Voltage divider sampling circuit; 1-Thermistor; 11-First terminal; 12-Second terminal; 2-Adjustable reference resistance module; 2a-First adjustable reference resistance module; 21a-First stage controller; 22a-First reference sub-resistor; 22a1-First-stage first reference sub-resistor; 22a-Second-stage first reference sub-resistor; 22aN-Nth-stage first reference sub-resistor; 2b-Second adjustable reference resistance module; 21b-Second stage controller; 22b1-First-stage second reference sub-resistor; 22b2-Second-stage second reference sub-resistor; 22b3-Third-stage second reference sub-resistor; 22bM-Mth-stage second reference sub-resistor; 21-Stage controller; 22-Reference resistor; 221-First-stage reference resistor; 222-Second-stage reference resistor; 223-Third-stage reference resistor; 224-Fourth-stage reference resistor; 3-Sampling circuit; 4-Control circuit.

## DESCRIPTION OF EMBODIMENTS

To better understand the technical solutions of the present disclosure, the embodiments of the present disclosure will be described in detail below with reference to the accompanying drawings.

It should be clear that the described embodiments are only some of the embodiments of the present disclosure, not all of the embodiments.

The terms used in the embodiments of the present disclosure are only for the purpose of describing specific embodiments and are not intended to limit the present disclosure. The singular forms "a/an", "the" and "said" used in the embodiments of the present disclosure and the appended claims are also intended to include plural forms, unless the context clearly indicates otherwise.

It should be understood that the term "and/or" used herein is only an associated relationship describing associated objects, indicating that there can be three relationships. For example, A and/or B refers to: A exists alone, both A and B exist simultaneously, and B exists alone. In addition, the character "/" herein generally indicates an "or" relationship between the associated objects.

A power conversion system (PCS) is a bidirectional current controllable conversion device that connects an energy storage battery system with the power grid. It can accurately and rapidly adjust voltage, frequency, and power between the power grid and the energy storage system, so as to realize constant-power and constant-current charging and discharging, as well as smooth the output of fluctuating power sources. The electronic components in the PCS are very sensitive to temperature. Excessively high temperatures may cause decline in the performance of these components and may even lead to permanent damage. Therefore, it is necessary to provide a temperature sampling circuit to monitor the ambient temperature in the PCS in real-time, so that timely measurements (such as cooling, reducing load, etc.) can be taken to avoid overheating, thereby extending the service life of the electronic components and of the entire energy storage system.

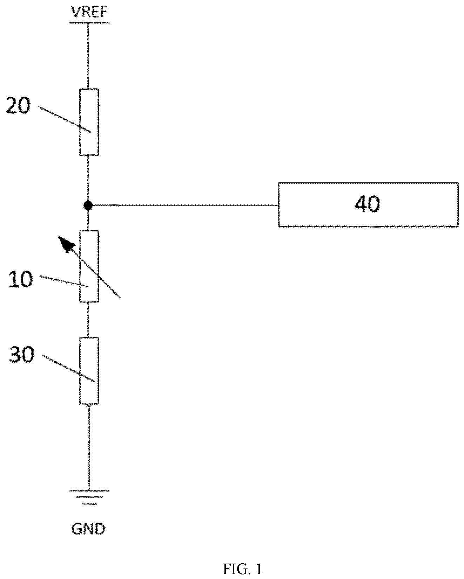

FIG. 1 shows a circuit structure diagram of a temperature sampling circuit in the related art. As shown in FIG. 1, the temperature sampling circuit includes a negative temperature coefficient thermistor (NTC) 10, a first reference resistor 20, a second reference resistor 30, and a voltage divider sampling circuit 40. The first reference resistor 20 and the second reference resistor 30 are respectively connected in series at both ends of the NTC. Both the first reference resistor 20 and the second reference resistor 30 are resistors with fixed resistance values, and their resistance values match the normal-temperature resistance value of the NTC. The voltage divider sampling circuit can take a point at either the upper end or the lower end of the NTC to sample the voltage, the real-time resistance value of the thermistor is calculated from the sampled voltage division based on the voltage divider ratio, and then the ambient temperature can be obtained by looking up the resistance-temperature comparison table (R-T table) of the NTC.

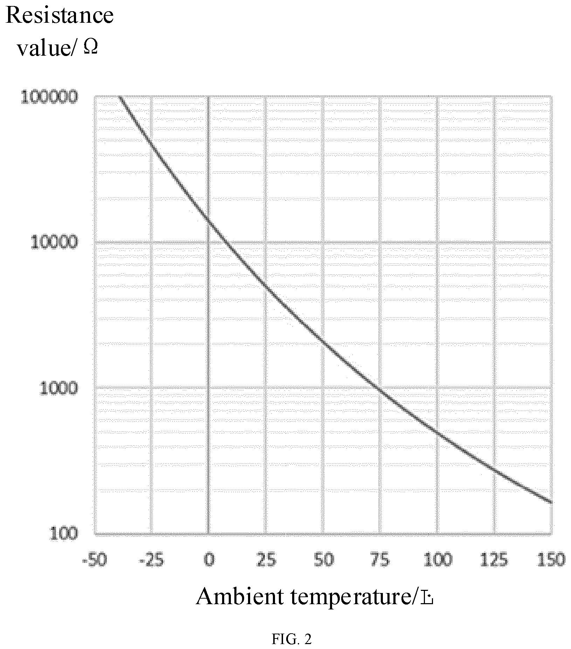

FIG. 2 is a resistance-temperature comparison table of the NTC in some embodiments. The abscissa represents the ambient temperature, and the ordinate represents the resistance value of the NTC. As can be seen from FIG. 2, the resistance value of the NTC at 25°C is 5kΩ. Taking the resistance values of both the first reference resistor 20 and the second reference resistor 30 as 5kΩ and the reference source (VREF) as 12V as an example:

4

$$\text{Sampling voltage} = 12 \times \frac{5000 + NTC}{5000 + 5000 + NTC} \qquad \text{formula (1).}$$

When the ambient temperature is low, for example, when the ambient temperature is -30°C and -35°C, the resistance values of the NTC are 60.94kΩ and 80.39kΩ respectively. Without considering errors, according to the above formula (1), the voltage divisions of the sampling circuit can be obtained as approximately 11.15V and 11.34V respectively. That is, a difference in the theoretical voltage division of the sampling circuit corresponding to a temperature difference of 5°C is approximately 0.19V.

When the ambient temperature is high, for example, when the ambient temperature is 80°C and 85°C, the resistance values of the NTC are 832Ω and 725Ω, respectively. Without considering errors, according to the above formula (1), the voltage divisions of the sampling circuit can be obtained as approximately 6.461V and 6.406V respectively. That is, a difference in the theoretical voltage division of the sampling circuit corresponding to a temperature difference of 5°C is approximately 0.055V.

Therefore, when the ambient temperature is low, the resistance value of the NTC is much greater than that of the reference resistor, and the error of the NTC itself will have a great impact on the sampling accuracy, resulting in inaccurate temperature detection results. When the ambient temperature is high, the resistance value of the NTC is much smaller than that of the reference resistor, the difference in the theoretical voltage division of the sampling circuit at different temperatures is very small, and the errors of the reference source and the reference resistor will have a great impact on the sampling accuracy, resulting in inaccurate temperature detection results. Moreover, the greater the resistance value of the reference resistor, the more obvious the impact on the sampling accuracy at high temperatures. In other words, the reference resistor cannot ensure the sampling accuracy of the thermistor within the full temperature range, but can only ensure the sampling accuracy within a specific temperature range.

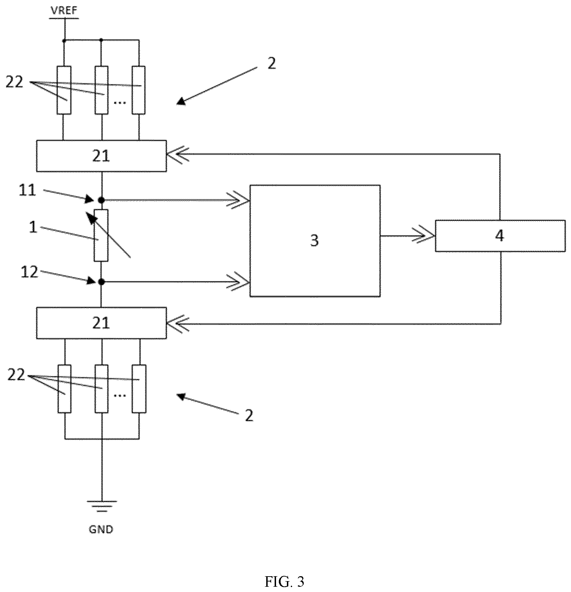

To solve the above problems, embodiments of the present disclosure provide a temperature sampling circuit that can be used to detect the ambient temperature in a power conversion system. As shown in FIG. 3, the temperature sampling circuit includes a thermistor 1, an adjustable reference resistance module 2, a sampling circuit 3, and a control circuit 4. The thermistor 1 is a negative temperature coefficient thermistor, and its resistance value decreases as the temperature increases. The thermistor 1 has a first terminal 11 and a second terminal 12. The first terminal 11 is connected to the power supply voltage, and the second terminal 12 is grounded. The adjustable reference resistance module 2 is connected to at least one of the first terminal 11 and the second terminal 12. The adjustable reference resistance module 2 has multiple reference resistance values of different stages, and the reference resistance values of different stages correspond to different preset sampling voltage ranges. The sampling circuit 3 has a sampling terminal and a sampling circuit output terminal. The sampling terminal is connected to at least one of the first terminal 11 and the second terminal 12 to obtain a sampling voltage value, and the sampling voltage value is the voltage division at the sampling point. The control circuit 4 has a control circuit input terminal and a control circuit output terminal. The control circuit input terminal is connected to the sampling circuit output terminal to receive the sampling voltage value, and the control circuit output terminal is connected to the adjustable reference resistance module 2 to send a control signal to the adjustable reference resistance module 2. The control circuit 4 is used to determine a resistance value of the thermistor 1 based on the sampling voltage value when the sampling voltage value meets a preset sampling voltage range corresponding to a reference resistance value of the current stage. The control circuit 4 is also used to switch to a reference resistance value of another stage when the sampling voltage value does not meet a preset sampling voltage range corresponding to a reference resistance value of the current stage, so that the newly obtained sampling voltage value meets a preset sampling voltage range corresponding to the reference resistance value of the switched stage.

The reference resistance value of each stage corresponds to a specific temperature range. The reference resistance value of this stage has the least impact on the accuracy of the sampling voltage value within the corresponding temperature range. Given that the power supply voltage (reference source, VREF) is determined, a corresponding sampling voltage value range can be obtained based on the reference resistance value of this stage and the resistance-value range of the thermistor 1 within the corresponding temperature range. The obtained sampling voltage value range is the preset sampling voltage range corresponding to the reference resistance value of this stage.

The specific working process of the temperature sampling circuit is as follows. First, the adjustable reference resistance module 2 is set to a certain stage. That is, a reference resistance value is selected first. Then, the sampling terminal of the sampling circuit 3 obtains the sampling voltage value at the current stage, and the data of this sampling voltage value is transmitted to the control circuit input terminal through the sampling circuit output terminal. Control circuit 4 can make a determination on the sampling voltage value after receiving it. If the sampling voltage value meets the preset sampling voltage range corresponding to the reference resistance value of the current stage, it indicates that the reference resistance value of the current stage is suitable for the thermistor 1 within its current temperature range. The control circuit 4 can calculate the current resistance value of the thermistor 1 based on this sampling voltage value, and query the resistance-temperature comparison table of the thermistor 1 according to the obtained resistance value of the thermistor 1, so as to obtain the current ambient temperature.

If the sampling voltage value does not meet the preset sampling voltage range corresponding to the reference resistance value of the current stage, it indicates that the reference resistance value of the current stage is not suitable for the thermistor 1 within its current temperature range. The control circuit output terminal of the control circuit 4 can send a signal to the adjustable reference resistance module 2 to control the adjustable reference resistance module 2 to switch to a reference resistance value of another stage. The sampling terminal of the sampling circuit 3 obtains the new sampling voltage value at the new stage, and the data of the new sampling voltage value is transmitted to the control circuit input terminal through the sampling circuit output terminal. Control circuit 4 can make a determination on the new sampling voltage value after receiving it. If the new sampling voltage value meets the preset sampling voltage range corresponding to the reference resistance value of the new stage, it indicates that the reference resistance value of the new stage is suitable for the thermistor 1 within the current temperature. The control circuit 4 can calculate the current resistance value of the thermistor 1 based on the new sampling voltage value, and query the resistance-temperature comparison table of the thermistor 1 according to the obtained resistance value of the thermistor 1, so as to obtain the current ambient temperature. If the new sampling voltage value still does not meet the preset sampling voltage range corresponding to the reference resistance value of the new stage, the above steps are repeated. That is, the adjustable reference resistance module 2 is controlled to continue to switch to the reference resistance value of another stage, the sampling circuit 3 obtains the sampling voltage value again, and the control circuit 4 make a determination on the new sampling voltage value until the new sampling voltage value meets the preset sampling voltage range corresponding to the reference resistance value of the new stage.

In the temperature sampling circuit according to some embodiments of the present disclosure, the dynamic adjustment of the reference resistance value in the temperature sampling circuit can be achieved by setting the adjustable reference resistance module 2 having multiple reference resistance values of different stages and using the control circuit 4 to achieve the stage adjustment of the adjustable reference resistance module 2. This enables dynamic adjustment of the reference resistance value in the temperature sampling circuit according to the resistance value range of the thermistor 1, so that there is always a suitable reference resistance value for the thermistor 1 at different ambient temperatures. That is, the temperature sampling circuit provided by the present disclosure can achieve precise matching between the reference resistance value and the thermistor 1 within the full temperature range, reducing the influence of errors in the reference power supply, reference resistance value, and the thermistor 1 itself on the sampling accuracy, thereby improving the sampling accuracy within the full temperature range and ensuring the accuracy of the finally obtained ambient temperature results. Moreover, the temperature sampling circuit provided by embodiments of the present disclosure does not require the use of an additional high-precision reference source or precision resistor, thereby effectively controlling the hardware cost of the temperature sampling circuit.

The matching standard between the reference resistance value and the temperature range should meet that a smaller reference resistance value corresponds to a higher temperature range to reduce the impact of errors in the reference source and the reference resistance value on the sampling accuracy when the ambient temperature is high, and a greater reference resistance value corresponds to a lower temperature range to reduce the impact of the error of the thermistor 1 itself on the sampling accuracy when the ambient temperature is low, thus ensuring the accuracy of the temperature detection results of the temperature sampling circuit within the full temperature range.

In one or more embodiments, the sampling circuit 3 includes an analog-to-digital converter (ADC) module. The ADC module has an ADC module input terminal and an ADC module output terminal. The ADC module input terminal is the sampling terminal, and the ADC module output terminal is the sampling circuit output terminal. The ADC module can convert the continuously varying analog signal (sampling voltage value) collected through the ADC input terminal into a discrete digital signal, and output this digital signal to the control circuit input terminal through the ADC output terminal. The sampling circuit 3 may also include an operational amplifier or other processing modules for signal processing of the sampling voltage value, which is not limited by the embodiments of the present disclosure. The control circuit 4 can achieve functions such as data analysis, data storage, and circuit control using a digital signal processor (DSP) chip. It can also use other chips with data analysis and circuit control functions, which is not limited by the embodiments of the present disclosure.

In one or more embodiments, as shown in FIG. 3, the adjustable reference resistance module 2 includes a stage controller 21 and multiple reference resistors 22 with different resistance values. Each reference resistor 22 corresponds to a stage. The stage controller 21 is connected to at least one of the first terminal 11 and the second terminal 12. The stage controller 21 is also connected to the control circuit output terminal. The control circuit output terminal is used to send a control signal to the stage controller 21 to control the reference resistor 22 with the corresponding resistance value to be connected in series with the thermistor 1. Therefore, when it is necessary to switch to the reference resistance value of another stage, it only needs to control the reference resistor 22 with another resistance value to be connected in series with the thermistor 1 through the control circuit 4.

In some embodiments, the stage controller 21 can be a single-pole multi-throw switch. The fixed terminal of the single-pole multi-throw switch is connected to the thermistor 1, while multiple movable terminals of the single-pole multi-throw switch are respectively used to be connected to multiple reference resistors 22. In addition, the single-pole multi-throw switch can also be connected to the control circuit output terminal to receive the control signal sent by the control circuit output terminal, and achieve the conduction between the fixed terminal and the corresponding movable terminal based on this control signal, thus realizing the series connection of the corresponding reference resistor 22 and the thermistor 1. At this time, the rest of the movable terminals are all disconnected to the fixed terminal. When it is necessary to switch to the reference resistance value of another stage, it only needs to control the disconnection between the movable terminal corresponding to the reference resistor 22 of the current stage and the fixed terminal through the control circuit 4, and control the conduction between the movable terminal corresponding to the reference resistor 22 of the required stage and the fixed terminal.

Alternatively, the stage controller 21 can be composed of multiple MOS transistors. The drains of the multiple MOS transistors are respectively connected to the thermistor 1, the sources of the multiple MOS transistors correspond one-to-one to multiple reference resistors 22 with different resistance values, and the gates of the multiple MOS transistors are respectively connected to the control circuit output terminal. The control circuit output terminal is used to send control signals to the multiple MOS transistors respectively, so as to control the conduction between the MOS transistor corresponding to the reference resistor 22 of the required stage and the reference resistor 22 of the required stage, and control the disconnection between the MOS transistors corresponding to the reference resistors 22 of the remaining stages and the reference resistors 22 of the remaining stages, thus realizing the series connection of the corresponding reference resistor 22 and the thermistor 1. When it is necessary to switch to the reference resistance value of another stage, it only needs to control the disconnection between the MOS transistor corresponding to the reference resistor 22 of the current stage and the reference resistor 22 of the current stage through the control circuit 4, and control the conduction between the MOS transistor corresponding to the reference resistor 22 of the required stage and the reference resistor 22 of the required stage.

Therefore, the structure and control method of the adjustable reference resistance module 2 provided by the embodiments of the present disclosure are relatively simple, which is conducive to further reducing the hardware cost of the temperature sampling circuit.

In one or more embodiments, the temperature sampling circuit may include only one adjustable reference resistance module 2, and this adjustable reference resistance module 2 includes at least two reference resistors 22 with different resistance values. When the adjustable reference resistance module 2 is connected to the first terminal 11, the sampling terminal should be connected to the first terminal 11. When the adjustable reference resistance module 2 is connected to the second terminal 12, the sampling terminal should be connected to the second terminal 12.

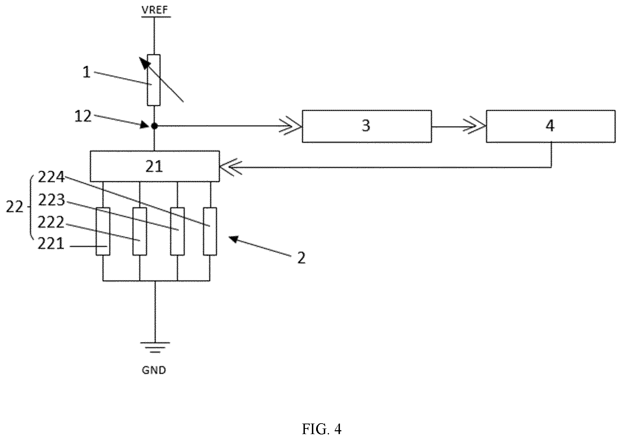

As shown in FIG. 4, the following takes the case where the adjustable reference resistance module 2 is connected to the second terminal 12 and the adjustable reference resistance module 2 includes four reference resistors 22 with different resistance values as an example, to introduce the specific working process of the temperature sampling circuit in detail. For example, the four reference resistors 22 with different resistance values are respectively the first-stage reference resistor 221, the second-stage reference resistor 222, the third-stage reference resistor 223, and the fourth-stage reference resistor 224. The first-stage reference resistor 221 corresponds a first preset sampling voltage range {VT1}, the second-stage reference resistor 222 corresponds a second preset sampling voltage range {VT2}, the third-stage reference resistor 223 corresponds a third preset sampling voltage range {VT3}, and the fourth-stage reference resistor 224 corresponds a fourth preset sampling voltage range {VT4}. The sampling voltage value satisfies the following formula:

$$\text{Sampling voltage value} = \text{VREF} \times \frac{R}{R+NTC} \qquad \text{formula (2)}.$$

VREF is the power supply voltage value, R is the resistance value of the reference resistor 22, and NTC is the resistance value of the thermistor 1.

During sampling, the adjustable reference resistance module 2 is first set to a certain stage, for example, to the first stage. At this time, the resistance value R of the reference resistor 22 is the resistance value of the first-stage reference resistor 221. Then, the sampling terminal obtains the sampling voltage value at the first stage, and the control circuit 4 make a determination on this sampling voltage value. If this sampling voltage value falls within the first preset sampling voltage range {VT1}, the control circuit 4 can substitute this sampling voltage value and the resistance value of the first-stage reference resistor 221 into the above-mentioned formula (2) to obtain the current resistance value of the thermistor 1, and query the resistance-temperature comparison table of the thermistor 1 according to the obtained resistance value of the thermistor 1, so as to obtain the current ambient temperature.

If this sampling voltage value does not fall within the first preset sampling voltage range {VT1}, the control circuit 4 controls the stage controller 21 to switch to the reference resistor 22 of another stage, for example, to the second-stage reference resistor 222. At this time, the resistance value R of the reference resistor 22 is the resistance value of the second-stage reference resistor 222. Then, the sampling terminal obtains the sampling voltage value at the second stage, and the control circuit 4 make a determination on the new sampling voltage value. If the new sampling voltage value falls within the second preset sampling voltage range {VT2}, the control circuit 4 can substitute the new sampling voltage value and the resistance value of the second-stage reference resistor 222 into the above-mentioned formula (2) to obtain the current resistance value of the thermistor 1, and query the resistance-temperature comparison table of the thermistor 1 according to the obtained resistance value of the thermistor 1, so as to obtain the current ambient temperature.

If the new sampling voltage value does not fall within the second preset sampling voltage range {VT2}, the control circuit 4 controls the stage controller 21 to switch to the reference resistor 22 of another stage, for example, to the third-stage reference resistor 223, and the above sampling and analysis steps are repeated, which will not be elaborated on here.

It should be noted that the resistance values of the first-stage reference resistor 221, the second-stage reference resistor 222, the third-stage reference resistor 223, and the fourth-stage reference resistor 224 can either increase or decrease in sequence, which is not limited by the embodiments of the present disclosure.

In some other embodiments, as shown in FIG. 3, the temperature sampling circuit may include two adjustable reference resistance modules 2. One of the two adjustable reference resistance modules 2 is connected to the first terminal 11, and the other is connected to the second terminal 12. The sampling terminal is connected to at least one of the first terminal 11 and the second terminal 12. When the sampling terminal is only connected to the first terminal 11, the sampling voltage value is the voltage-division value of the thermistor 1 and the second adjustable reference resistance module 2. When the sampling terminal is only connected to the second terminal 12, the sampling voltage value is the voltage-division value of the second adjustable reference resistance module 2. When the sampling terminal is connected to both the first terminal 11 and the second terminal 12, the voltage-division value of the thermistor 1 can be obtained by differential sampling. The embodiments of the present disclosure does not limit the specific connection position of the sampling terminal, and all of the above three connection methods are applicable. However, among the three methods, only the differential sampling method can be applied to the situation where the reference ground of the adjustable reference resistance module 2 is different from the reference ground of the sampling circuit 3.

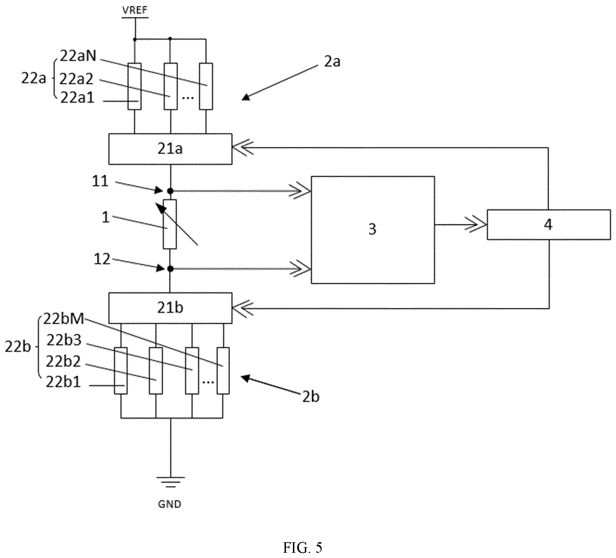

For example, as shown in FIG. 5, the two adjustable reference resistance modules 2 are respectively the first adjustable reference resistance module 2a and the second adjustable reference resistance module 2b. The first adjustable reference resistance module 2a includes a first stage controller 21a and N first reference sub-resistors 22a with different resistance values, where N≥2 and N is an integer. The second adjustable reference resistance module 2b includes a second stage controller 21b and M second reference sub-resistors 22b with different resistance values, where M≥2 and M is an integer. N and M can be equal or not equal.

The first stage controller 21a and the second stage controller 21b are respectively used to be connected to the control circuit output terminal, so that the control circuit output terminal can send control signals to the first adjustable reference resistance module 2a and the second adjustable reference resistance module 2b, respectively, thus realizing the independent control of the first adjustable reference resistance module 2a and the second adjustable reference resistance module 2b. In this case, when the first adjustable reference resistance module 2a includes N first reference sub-resistors 22a with different resistance values and the second adjustable reference resistance module 2b includes M second reference sub-resistors 22b with different resistance values. Different first reference sub-resistors 22a and different second reference sub-resistors 22b can be respectively connected in series with the thermistor 1 at the same time, so that the reference resistance value in the temperature sampling circuit has a variety of combination situations. That is, the number of stages in the temperature sampling circuit can be increased, and each stage can correspond to a more accurate temperature range, which is beneficial to improving the accuracy of the temperature detection results.

As shown in FIG. 5, the N first reference sub-resistors 22a with different resistance values are respectively the first-stage first reference sub-resistor 22a1, the second-stage first reference sub-resistor 22a2, ......, and the N-th-stage first reference sub-resistor 22aN. The M second reference sub-resistors 22b with different resistance values are respectively the first-stage second reference sub-resistor 22b1, the second-stage second reference sub-resistor 22b2, the third-stage second reference sub-resistor 22b3, ......, and the M-th-stage second reference sub-resistor 22bM. Correspondingly, there can be M*N combinations for the reference resistance values in the temperature sampling circuit.

In one or more embodiments, the first adjustable reference resistance module 2a can be set as a coarse-adjustment module. That is, the resistance-value differences among the N different first reference sub-resistors 22a can be set to be relatively large. In addition, the second adjustable reference resistance module 2b can be set as a fine-adjustment module, that is, the resistance-value differences among the M different second reference sub-resistors 22b can be set to be relatively small. In some embodiments of the present disclosure, the resistance value of any first reference sub-resistor 22a can be set to be greater than that of any second reference sub-resistor 22b. In this way, during sampling, if the difference between the sampling voltage value and the preset sampling voltage range of the current stage is too large, the first adjustable reference resistance module 2a is adjusted to switch to the first reference sub-resistor 22a of a different stage. If the difference between the sampling voltage value and the preset sampling voltage range of the current stage is relatively small, the second adjustable reference resistance module 2b is adjusted to switch to the second reference sub-resistor 22b of a different stage, thus realizing the flexible adjustment of the reference resistance value.

Embodiments of the present disclosure also provide a temperature detection method, which is used to detect the temperature in the power conversion system using the temperature sampling circuit described in any of the above-mentioned embodiments. The temperature sampling circuit may include one adjustable reference resistance module or two adjustable reference resistance modules. When the temperature sampling circuit includes two adjustable reference resistance modules 2, the sampling terminal can be connected to the first terminal 11 of the thermistor 1, the second terminal 12 of the thermistor 1, or both the first terminal 11 and the second terminal 12 simultaneously.

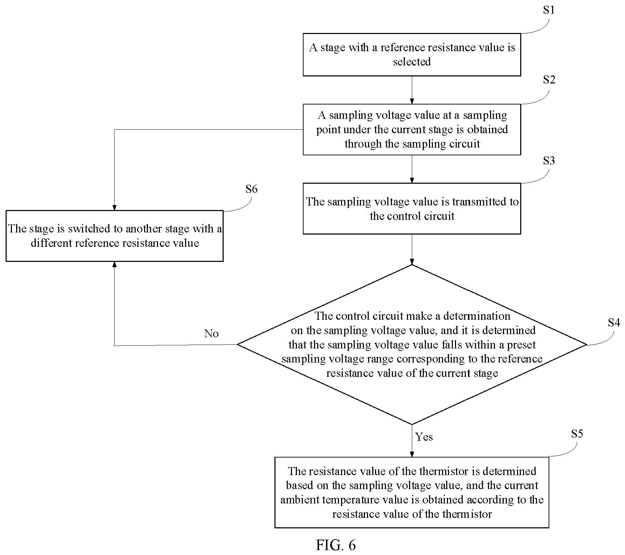

As shown in FIG. 6, the temperature detection method includes the following steps.

S1: a stage with a reference resistance value is selected.

In this step, according to the predicted temperature, the reference resistance value of any stage can be selected as the default stage. That is, any reference resistor 22 can be selected to be connected in series with the thermistor 1.

S2: a sampling voltage value at a sampling point under the current stage is obtained through the sampling circuit 3.

S3: the sampling voltage value is transmitted to the control circuit 4.

In the above-mentioned steps S2 and S3, the sampling terminal of the sampling circuit 3 obtains the sampling voltage value at the default stage, and the data of this sampling voltage value is transmitted to the control circuit input terminal of the control circuit 4 through the sampling circuit output terminal, so that the control circuit 4 can perform data processing on the sampling voltage value.

S4: the control circuit 4 make a determination on the sampling voltage value, and it is determined that the sampling voltage value falls within a preset sampling voltage range corresponding to the reference resistance value of the current stage.

In this step, the control circuit 4 is used to analyze the received sampling voltage value and determine whether the current sampling voltage value falls within the preset sampling voltage range corresponding to the reference resistor 22 of the current stage.

If the sampling voltage value meets the preset sampling voltage range corresponding to the reference resistance value of the current stage, step S5 is performed. That is, the resistance value of the thermistor 1 is determined based on the sampling voltage value, and the current ambient temperature value is obtained according to the resistance value of the thermistor 1.

If the sampling voltage value does not meet the preset sampling voltage range corresponding to the reference resistance value of the current stage, step S6 is performed. That is, the stage is switched to the reference resistance value of another stage. Then the steps S2 to S4 is performed repeatedly, namely, the sampling circuit 3 obtains the sampling voltage value of the sampling point at the switched stage, and the control circuit 4 continues to make a determination on the newly obtained sampling voltage value.

For step S5, the temperature detection method includes that the control circuit 4 calculates the resistance value of the thermistor 1 based on the sampling voltage value, and the control circuit 4 retrieves the corresponding resistance-temperature comparison table of the thermistor 1, and obtains the current ambient temperature value by looking up the table based on the resistance value of the thermistor 1.

In this step, the control circuit 4 is used to store the data of the preset sampling voltage ranges corresponding to the reference resistance values of all stages and the resistance-temperature comparison tables of the thermistor 1 corresponding to all preset sampling voltage ranges. The control circuit 4 can analyze the sampling voltage value to determine whether the current sampling voltage value falls within the preset sampling voltage range corresponding to the reference resistor 22 of the current stage, and also calculate the current resistance value of the thermistor 1 based on the current sampling voltage value, and retrieve the corresponding resistance-temperature comparison table of the thermistor 1 according to this resistance value, so as to output the current ambient temperature value. That is, the control circuit 4 has functions such as data processing and analysis, data storage and data calculation, and it can achieve automated temperature detection.

For step S6, the control circuit 4 can send a signal to the stage controller 21 to control the stage controller 21 to connect the reference resistors 22 with different resistance values in series with the thermistor 1, which is not elaborate further herein.

In one or more embodiments, for step S6, the temperature detection method includes that if the sampling voltage value is greater than the upper limit of the preset sampling voltage range of the reference resistance value of the current stage, the stage is switched to a stage with a greater reference resistance value, or if the sampling voltage value is less than the lower limit of the preset sampling voltage range of the reference resistance value of the current stage, the stage is switched to a stage with a smaller reference resistance value.

Taking the temperature sampling circuit in FIG. 4 as an example, the adjustable reference resistance module 2 includes four reference resistors 22 with different resistance values, namely the first-stage reference resistor 221, the second-stage reference resistor 222, the third-stage reference resistor 223, and the fourth-stage reference resistor 224. The resistance values of the first-stage reference resistor 221, the second-stage reference resistor 222, the third-stage reference resistor 223, and the fourth-stage reference resistor 224 increase in sequence. The first-stage reference resistor 221 corresponds to a first preset sampling voltage range {VT1}, the second-stage reference resistor 222 corresponds to a second preset sampling voltage range {VT2}, the third-stage reference resistor 223 corresponds to a third preset sampling voltage range {VT3}, and the fourth-stage reference resistor 224 corresponds to a fourth preset sampling voltage range {VT4}.

During sampling, the adjustable reference resistance module 2 can be first set at the second stage. The control circuit 4 make a determination on the sampling voltage value at the second stage. If this sampling voltage value does not fall within the second preset sampling voltage range {VT2} and the sampling voltage value is greater than the second preset sampling voltage range {VT2}, it indicates that the voltage division of the adjustable reference resistance module 2 is too small at this time, and the reference resistance value needs to be increased. Therefore, the stage of the adjustable reference resistance module 2 can be switched to the third stage with a greater reference resistance value.

If this sampling voltage value does not fall within the second preset sampling voltage range {VT2} and the sampling voltage value is less than the second preset sampling voltage range {VT2}, it indicates that the voltage division of the adjustable reference resistance module 2 is too large, and the reference resistance value needs to be decreased. Therefore, the stage of the adjustable reference resistance module 2 can be switched to the first stage with a smaller reference resistance value.

When the stage adjustment in the step S6 is implemented in the above-mentioned manner, the efficiency of stage adjustment can be improved, thereby improving the efficiency of temperature detection.

In one or more embodiments, before performing the step S1, the temperature detection method further includes the following steps.

A1: the number of stages of the adjustable reference resistance module 2 and reference resistance values of all stages are determined based on a range of an ambient temperature to be measured.

In this step, the number of stages of the adjustable reference resistance module 2 and the reference resistance values of all stages are first determined according to the measured temperature range and the measurement accuracy requirements. The reference resistance value of each stage corresponds to a temperature range. It is necessary to ensure that the resistance value of each stage has the least impact on the sampling accuracy within its corresponding temperature range, thus ensuring the accuracy of the temperature detection results.

It is noted that the number of stages and the resistance value of the reference resistor of each stage is not limited by the embodiments of the present disclosure, which can be designed according to the temperature measurement range or the requirements of temperature measurement accuracy.

A2: resistance-temperature comparison tables of the thermistor 1 corresponding to different stages is established based on temperature characteristics of the thermistor 1

In this step, the resistance-temperature comparison table of the same thermistor 1 is fixed. According to the temperature ranges corresponding to the reference resistance values of all stages designed in step A1, the complete resistance-temperature comparison table can be divided into multiple appropriate resistance-temperature comparison tables. These multiple resistance-temperature comparison tables correspond one-to-one to the temperature ranges of the reference resistance values of multiple stages. That is, the reference resistance value of each stage has its own resistance-temperature comparison table, which makes it more convenient for the control circuit 4 to retrieve and process data.

A3: a sampling point is selected and preset sampling voltage ranges corresponding to the reference resistance values of all stages are set according to actual circuit parameters of the sampling point.

In this step, based on the power supply voltage, the reference resistance values of all stages, and the resistance-value ranges of the thermistor 1 within the temperature ranges corresponding to the reference resistance values of all stages, the sampling voltage value ranges corresponding to the reference resistance values of all stages can be obtained. That is, the preset sampling voltage ranges corresponding to the reference resistance values of all stages can be obtained.

It should be noted that there should be an overlapping part between the preset sampling voltage ranges corresponding to the reference resistance values of two adjacent stages to avoid the situation where the sampling voltage value does not meet the preset sampling voltage range corresponding to the reference resistance value of any stage.

In the temperature detection method according to some embodiments of the present disclosure, the control circuit is used to adjust the stages of the adjustable reference resistance module, which can achieve dynamic adjustment of the reference resistance value in the temperature sampling circuit. This enables dynamic adjustment of the reference resistance value in the temperature sampling circuit according to the resistance-value range of the thermistor 1, so that there is always a suitable reference resistance value for the thermistor 1 at different ambient temperatures. Thus, it effectively improves the sampling accuracy within the full temperature range and ensures the accuracy of the finally obtained ambient temperature result.

The above-mentioned content is only the preferred embodiments of the present disclosure and is not used to limit the present disclosure. For those skilled in the art, the present disclosure can have various modifications and changes. The scope of the present disclosure shall be defined by the appended claims.

**Claims**

1.  A temperature sampling circuit, applied in a power conversion system, **characterized in that**, the temperature sampling circuit comprises:

    a thermistor (1) having a first terminal (11) and a second terminal (12), wherein the first terminal (11) is configured to be connected to a power supply voltage, and the second terminal (12) is configured to be grounded;
    an adjustable reference resistor module (2) connected to at least one of the first terminal (11) and the second terminal (12), wherein the adjustable reference resistor module (2) has a plurality of stages of different reference resistance values, and the reference resistance values of different stages correspond to different preset sampling voltage ranges;
    a sampling circuit (3) having a sampling terminal and a sampling circuit output terminal, wherein the sampling terminal is connected to at least one of the first terminal (11) and the second terminal (12) to obtain a sampling voltage value; and
    a control circuit (4) having a control circuit input terminal and a control circuit output terminal, wherein the control circuit input terminal is connected to the sampling circuit output terminal to receive the sampling voltage value, and the control circuit output terminal is connected to the adjustable reference resistor module (2);
    the control circuit (4) is configured to determine a resistance value of the thermistor (1) based on the sampling voltage value in response to the sampling voltage value falling within a preset sampling voltage range corresponding to a reference resistance value of the current stage, and the control circuit (4) is further configured to switch to another stage with a different reference resistance value in response to the sampling voltage value not falling within a preset sampling voltage range corresponding to a reference resistance value of the current stage, so that a newly obtained sampling voltage value falls within a preset sampling voltage range corresponding to the reference resistance value of the stage after switching.

2.  The temperature sampling circuit according to claim 1, **characterized in that**, the adjustable reference resistor module (2) comprises a stage controller (21) and a plurality of reference resistors (22) with different resistance values, the stage controller (21) is connected to at least one of the first terminal (11) and the second terminal (12); and
    the stage controller (21) is further connected to the control circuit output terminal, the control circuit output terminal is configured to send a control signal to the stage controller (21) to control one of the plurality of reference resistors (22) with a corresponding resistance value to be connected in series with the thermistor (1).

3.  The temperature sampling circuit according to claim 1, **characterized in that**, the sampling circuit (3) comprises an analog-to-digital converter, ADC, module, the ADC module has an ADC module input terminal and an ADC module output terminal, the sampling terminal is the ADC module input terminal, and the sampling circuit output terminal is the ADC module output terminal.

4.  The temperature sampling circuit according to claim 1, **characterized in that**, the temperature sampling circuit comprises one adjustable reference resistor module (2); and

    when the adjustable reference resistor module (2) is connected to the first terminal (11), the sampling terminal is connected to the first terminal (11), or
    when the adjustable reference resistor module (2) is connected to the second terminal (12), the sampling terminal is connected to the second terminal (12).

5.  The temperature sampling circuit according to claim 1, **characterized in that**, the temperature sampling circuit comprises two adjustable reference resistor modules (2), one of the two adjustable reference resistor modules (2) is connected to the first terminal (11), and the other one of the two adjustable reference resistor modules (2) is connected to the second terminal (12); and
    the sampling terminal is connected to at least one of the first terminal (11) and the second terminal (12).

6.  The temperature sampling circuit according to claim 2, **characterized in that**, the adjustable reference resistor module (2) comprises a first adjustable reference resistor module (2a) and a second adjustable reference resistor module (2b), one of the first adjustable reference resistor module (2a) and the second adjustable reference resistor module (2b) is connected to the first terminal (11), and the other one of the first adjustable reference resistor module (2a) and the second adjustable reference resistor module (2b) is connected to the second terminal (12);

    the first adjustable reference resistor module (2a) and the second adjustable reference resistor module (2b) are respectively connected to the control circuit output terminal, such that the control circuit output terminal is capable of respectively sending control signals to the first adjustable reference resistor module (2a) and the second adjustable reference resistor module (2b);

the first adjustable reference resistor module (2a) comprises N first reference sub-resistors (22a) with different resistance values, where N≥2 and N is an integer; and

the second adjustable reference resistor module (2b) comprises M second reference sub-resistors (22b) with different resistance values, where M≥2 and M is an integer.

7. The temperature sampling circuit according to claim 6, **characterized in that**, one of the first adjustable reference resistor module (2a) and the second adjustable reference resistor module (2b) is a coarse-adjustment module, and the other one of the first adjustable reference resistor module (2a) and the second adjustable reference resistor module (2b) is a fine-adjustment module.

8. The temperature sampling circuit according to claim 7, **characterized in that**, the coarse-adjustment module has a greater resistance value difference between adjacent reference sub-resistors than the fine-adjustment module.

9. The temperature sampling circuit according to any one of claims 1-8, **characterized in that**, resistance values of the plurality of stages progressively increase or decrease.

10. A power conversion system, comprising the temperature sampling circuit according to any one of claims 1-9.

11. A temperature detection method, applied in temperature detection of a power conversion system by a temperature sampling circuit, the temperature sampling circuit comprises a thermistor (1), an adjustable reference resistor module (2), a sampling circuit (3), and a control circuit (4), the adjustable reference resistor module (2) has a plurality of stages of different reference resistance values, and the reference resistance values of different stages correspond to different preset sampling voltage ranges,

**characterized in that**, the temperature detection method comprises:

selecting a stage with a reference resistance value;
obtaining, by the sampling circuit (3), a sampling voltage value at a sampling point under the current stage;
transmitting the sampling voltage value to the control circuit (4);
determining, by the control circuit (4), the sampling voltage value:

when the sampling voltage value falls within a preset sampling voltage range corresponding to the reference resistance value of the current stage, determining a resistance value of the thermistor (1) based on the sampling voltage value, and obtaining a current ambient temperature value based on the resistance value of the thermistor (1), or
when the sampling voltage value does not fall within the preset sampling voltage range corresponding to the reference resistance value of the current stage, switching to another stage with a different reference resistance value, obtaining a new sampling voltage value at the sampling point under the stage after switching, and continue determining the new sampling voltage value.

12. The temperature detection method according to claim 11, **characterized in that**, the switching to another stage with a different reference resistance value comprises:

when the sampling voltage value exceeds an upper limit of the preset sampling voltage range corresponding to the reference resistance value of the current stage, switching to a stage with a greater reference resistance value; or
when the sampling voltage value is below a lower limit of the preset sampling voltage range corresponding to the reference resistance value of the current stage, switching to a stage with a smaller reference resistance value.

13. The temperature detection method according to claim 11, **characterized in that**, the determining a resistance value of the thermistor (1) and obtaining a current ambient temperature value comprises:

calculating, by the control circuit (4), the resistance value of the thermistor (1) based on the sampling voltage value; and
retrieving, by the control circuit (4), a resistance-temperature comparison table of the thermistor (1), and obtaining the current ambient temperature value by looking up the table based on the resistance value of the thermistor (1).

14. The temperature detection method according to claim 11, **characterized in that**, prior to selecting a stage with a reference resistance value, the temperature detection method further comprises:

determining the number of stages of the adjustable reference resistor module (2) and reference resistance values of all stages based on a range of an ambient temperature to be measured;
establishing resistance-temperature comparison tables of the thermistor (1) corresponding to different stages based on temperature characteristics of the thermistor (1); and
selecting a sampling point and setting preset sampling voltage ranges corresponding to reference resistance values of all stages based on actual circuit parameters of the sampling point.

15. The temperature detection method according to any one of claims 11-14, **characterized in that**, resistance values of the plurality of stages progressively increase or decrease.

FIG. 1

Resistance
value/ Ω

Ambient temperature/℃

FIG. 2

FIG. 3

FIG. 4

FIG. 5

S1

A stage with a reference resistance value is selected

S2

A sampling voltage value at a sampling point under the current stage is obtained through the sampling circuit

S3

The sampling voltage value is transmitted to the control circuit

S6

The stage is switched to another stage with a different reference resistance value

S4

The control circuit make a determination on the sampling voltage value, and it is determined that the sampling voltage value falls within a preset sampling voltage range corresponding to the reference resistance value of the current stage

No

Yes

S5

The resistance value of the thermistor is determined based on the sampling voltage value, and the current ambient temperature value is obtained according to the resistance value of the thermistor

FIG. 6

Europäisches
Patentamt

European
Patent Office

Office européen
des brevets

## EUROPEAN SEARCH REPORT

**Application Number**

**EP 25 15 9730**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 112 504 499 A (CHINABEST HOME APPLIANCE CO LTD) 16 March 2021 (2021-03-16)<br>* abstract *<br>* paragraphs [0001], [0007], [0027] - [0032] *<br>* figure 1 *<br>----- | 1-15 | INV.<br>G01K7/21<br>G01K7/25<br>G01K15/00 |
| X | CN 113 108 936 A (GUANGZHOU XPENG AUTOMOBILE TECH CO LTD) 13 July 2021 (2021-07-13)<br>* abstract *<br>* paragraphs [0005], [0010], [0014] - [0020], [0024] *<br>* figures 4,5 *<br>----- | 1,15 | |

|  |
|---|
| TECHNICAL FIELDS SEARCHED (IPC) |
| G01K |

The present search report has been drawn up for all claims

| Place of search | Date of completion of the search | Examiner |
|---|---|---|
| The Hague | 1 August 2025 | Bagnera, Carlo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 9730

This annex lists the patent family members relating to the patent documents cited in  the above-mentioned European search report.
The members are as contained in the European Patent Office EDP file on
The European Patent Office is in no way liable for these particulars which are merely given for the purpose of information.

01-08-2025

| Patent document cited in search report | Publication date | Patent family member(s) | Publication date |
|---|---|---|---|
| CN 112504499 A | 16-03-2021 | NONE | |
| CN 113108936 A | 13-07-2021 | NONE | |

EPO FORM P0459

For more details about this annex : see Official Journal of the European Patent Office, No. 12/82